# FASCICULE DE BREVET EUROPEEN

(11) **EP 1 168 634 B1**
(45) Date de publication et mention de la délivrance du brevet: **13.06.2007**
(21) Numéro de dépôt: 00113102.8
(22) Date de dépôt: 28.06.2000
(51) Int. Cl.: H04B 1/16, H03J 7/06

(54) **Procédé de réduction de la consommation électrique d'un téléphone mobile cellulaire**
Verfahren zur Reduzierung des Elektrizitätsverbrauchs eines zellularen Mobiltelefons
Method for reducing the electricity consumption of a mobile cellular telephone

(43) Date de publication de la demande: 02.01.2002
(73) Titulaire: STMicroelectronics N.V., 1077 XX Amsterdam (NL)
(72) Inventeur: Arnaud, Thierry, 01220 Divonne-les-Bains (FR); Berens, Friedbert, 1202 Genève (CH)
(74) Mandataire: Casalonga, Axel

(56) Documents cités:
- EP-A- 0 351 230
- EP-A- 0 851 593
- EP-A- 0 865 167
- US-A- 5 055 802
- US-A- 5 111 162
- US-A- 5 950 120

## Description

L'invention concerne la transmission de l'information numérique sans fil, et plus particulièrement la téléphonie mobile cellulaire, en particulier celle destinée à fonctionner sous la norme UMTS (Universal Mobile Terrestrial Standard).

Un téléphone mobile cellulaire possède deux modes de fonctionnement, un mode dit actif et un mode d'attente ("Idle Mode" en langue anglaise). Dans le mode actif, qui correspond à un dialogue au cours d'une communication établie entre la station de base et le téléphone cellulaire, les chaînes d'émission et de réception du téléphone sont toutes les deux utilisées pour transférer de la voix ou des données numériques entre la station de base et le téléphone.

En-dehors d'une communication téléphonique, le téléphone cellulaire se place dans son mode d'attente. Dans ce mode d'attente, les chaînes d'émission et/ou de réception sont activées et désactivées à intervalles réguliers, de façon à maintenir une connexion régulière avec la station de base.

D'un point de vue structurel, outre l'étage d'émission/réception, qui comprend la chaîne d'émission et la chaîne de réception, le téléphone cellulaire comporte un étage de traitement, connecté à l'étage d'émission/réception et comportant des moyens de modulation/démodulation numérique généralement réalisés en partie en logique câblée et en partie de façon logicielle au sein d'un processeur de traitement du signal. Ce processeur effectue ainsi notamment la démodulation du signal reçu et la modulation du signal à transmettre.

Par ailleurs, différents signaux de référence (ayant des fréquences choisies) et d'horloge doivent être générés et délivrés respectivement à la chaîne d'émission, à la chaîne de réception ainsi qu'au processeur de modulation/démodulation. Les fréquences des signaux de référence fixent les fréquences d'émission et de réception.

Les différents signaux de référence et d'horloge sont délivrés par un étage synthétiseur de fréquence contrôlé par des moyens de contrôle automatique de fréquence. La précision requise pour la fréquence d'émission est typiquement de ± 0,1 ppm pour une fréquence nominale qui est dans la gamme 2 GHz.

Actuellement, l'architecture interne de l'étage synthétiseur de fréquence d'un téléphone mobile cellulaire se compose de boucles à verrouillage de phase classiques générant en sortie des oscillateurs de boucles, les signaux de référence destinés à l'étage d'émission/réception ainsi que le signal d'horloge destiné aux moyens de modulation/démodulation.

Le signal de base destiné à ces boucles à verrouillage de phase et formant une référence de fréquence pour les boucles, est issu d'un oscillateur contrôlé, par exemple un oscillateur contrôlé en tension et stable en température (oscillateur VTCXO), ayant la précision requise, c'est-à-dire ± 0,1 ppm. C'est donc essentiellement cet oscillateur qui conditionne la précision exigée, notamment pour la fréquence de transmission.

Sur la base de cette architecture, l'oscillateur contrôlé est toujours en fonctionnement, de même que la boucle à verrouillage de phase générant le signal d'horloge pour les moyens de modulation/démodulation et celle générant le signal de référence pour la chaîne d'émission.

Or, une telle structure présente des inconvéniens.

En effet, non seulement un tel oscillateur contrôlé est coûteux, mais sa consommation électrique pénalise l'autonomie du téléphone.

L'invention vise à apporter une solution à ce problème.

Un but de l'invention est d'optimiser la consommation électrique de l'émetteur/récepteur (téléphone) en optimisant celle de l'étage synthétiseur de fréquence en fonction du mode de fonctionnement du téléphone cellulaire.

L'invention a ainsi notamment pour but la génération des différents signaux d'horloge et de synchronisation, dans les différents modes de fonctionnement de l'émetteur/récepteur, en vue d'une réduction de la consommation électrique.

L'invention propose donc un procédé de réduction de la consommation électrique d'un émetteur/récepteur d'informations numériques, en particulier un téléphone mobile cellulaire, cet émetteur/récepteur comportant un étage synthétiseur de fréquence contrôlé par un algorithme de contrôle automatique de fréquence, cet étage synthétiseur de fréquence étant apte à délivrer au moins un signal de référence de fréquence choisie à l'étage d'émission/réception de l'émetteur/récepteur et un signal d'horloge-maître de fréquence choisie aux moyens de modulation/démodulation de l'émetteur/récepteur.

Selon une caractéristique générale de l'invention, on génère le ou les signaux de référence avec une précision (dite précision d'émission) prédéterminée, typiquement ± 0,1 ppm, à partir d'au moins une première boucle à verrouillage de phase à division fractionnaire contrôlée par l'algorithme de contrôle automatique de fréquence, cette boucle recevant (par exemple d'un oscillateur à quartz) un signal de base ayant une fréquence de base prédéterminée et une précision de base inférieure à ladite précision d'émission, typiquement une précision de base de l'ordre de ± 10 ppm.

On génère un signal d'horloge avec une précision prédéterminée (en général également la précision d'émission), à partir d'une deuxième boucle à verrouillage de phase à division fractionnaire contrôlée par l'algorithme de contrôle automatique de fréquence et recevant également le signal de base.

Lorsque l'étage d'émission/réception est inactif (par exemple en mode d'attente), on rend inactive la deuxième boucle à verrouillage de phase à division fractionnaire, le signal de base faisant alors office de signal d'horloge- maître. Et, lorsque l'étage d'émission/réception est actif, on active la deuxième boucle, le signal d'horloge généré par cette deuxième boucle faisant alors office de signal d'horloge-maître.

En d'autres termes, on réduit la consommation du téléphone en utilisant des boucles à verrouillage de phase à division fractionnaire recevant une référence fréquentielle d'un oscillateur à quartz peu précis, et en commutant la sortie de l'oscillateur sur l'entrée de l'étage de traitement lorsque l'étage d'émission/réception est inactif. Les boucles peuvent alors être désactivées.

Plus précisément, lorsque l'étage d'émission/réception, par exemple la chaîne d'émission, doit être activé (c'est-à-dire en mode actif lors d'une communication téléphonique, ou bien en mode d'attente à intervalles réguliers) les moyens de modulation/démodulation du téléphone contrôlent la deuxième boucle à verrouillage de phase (et bien entendu la ou les premières boucles) par l'intermédiaire de l'algorithme de contrôle automatique de fréquence (par démodulation d'un signal pilote émis par la station de base) de façon à permettre la génération d'une fréquence de référence d'émission très précise, typiquement à ± 0,1 ppm, destinée à la chaîne d'émission, et la génération du signal d'horloge-maître du processeur de traitement de signal.

Par contre, lorsque l'étage d'émission/réception est inactif, c'est-à-dire également à intervalles réguliers pendant le mode d'attente, il n'est nullement nécessaire de générer un signal de référence pour la chaîne d'émission. Seul le processeur de traitement du signal doit être activé. Et, dans ce cas, il a été observé qu'il était nullement nécessaire d'activer la deuxième boucle à verrouillage de phase. En effet, un signal d'horloge-maître, de précision moindre, par exemple ± 10 ppm, s'avère largement suffisant pour faire fonctionner l'étage de traitement. Et, ce signal d'horloge peu précis peut être alors délivré directement par exemple par un oscillateur de référence à quartz.

L'invention résulte notamment de l'observation qu'il existe, d'une part des instants au cours desquels il n'est nullement nécessaire d'élaborer des signaux de référence et des signaux d'horloge très précis puisque l'étage d'émission/réception, et notamment la chaîne d'émission, est inactif, et que, au cours de ces instants, un signal d'horloge de précision moindre est suffisant pour faire fonctionner l'étage de traitement.

L'invention résulte également de l'observation que lorsque l'étage d'émission/réception doit être activé, les moyens de modulation/démodulation ainsi que l'algorithme de contrôle automatique de fréquence, peuvent commencer à fonctionner avec un signal d'horloge peu précis jusqu'à ce que les différentes boucles à verrouillage de phase à division fractionnaire se soient verrouillées sur des fréquences précises avec une précision de l'ordre de ± 0,1 ppm, suite à la synchronisation sur un signal pilote.

Enfin, en combinaison avec ces observations, l'invention utilise des boucles à verrouillage de phase à division fractionnaire qui présentent la particularité de pouvoir délivrer des signaux en sortie avec des précisions très importantes, par exemple de l'ordre de quelques Hertz, à partir d'un signal de référence de base, délivré par exemple par un oscillateur à quartz de précision moindre que celle d'un oscillateur VTCXO, mais présentant par contre une consommation électrique moindre que celle de l'oscillateur VTCXO.

L'invention propose également un émetteur/récepteur, en particulier un téléphone mobile cellulaire, comportant un étage d'émission/réception, un étage de traitement connecté à l'étage d'émission/réception et comportant des moyens de modulation/démodulation et des moyens de contrôle automatique de fréquence, et un étage synthétiseur de fréquence contrôlé par les moyens de contrôle automatique de fréquence et apte à délivrer au moins un signal de référence de fréquence choisie à l'étage d'émission/réception et un signal d'horloge-maître de fréquence choisie aux moyens de modulation/démodulation.

Selon une caractéristique générale de l'invention, l'étage synthétiseur de fréquence comporte :
- au moins une première boucle à verrouillage de phase à division fractionnaire dont la sortie, reliée à l'étage d'émission/réception, est apte à délivrer, avec une précision d'émission prédéterminée, le signal de référence, et,
- une deuxième boucle à verrouillage de phase à division fractionnaire dont la sortie est apte à délivrer, avec une précision prédéterminée, un signal d'horloge.

Chaque boucle est apte à prendre sur commande un état actif et un état inactif et possède une entrée de contrôle reliée aux moyens de contrôle automatique de fréquence, ainsi qu'une entrée pour recevoir un signal de base issu d'un oscillateur et ayant une fréquence de base prédéterminée et une précision de base inférieure à ladite précision d'émission.

L'étage synthétiseur de fréquence comporte, par ailleurs, des moyens de commutation commandables possédant un premier état reliant la sortie de l'oscillateur aux moyens de modulation/démodulation et un deuxième état reliant la sortie de la deuxième boucle aux moyens de modulation/démodulation.

Par ailleurs, l'émetteur/récepteur comprend en outre des moyens de commande aptes à placer la deuxième boucle dans un état inactif et les moyens de commutation dans leur premier état, et à placer la deuxième boucle dans un état actif et les moyens de commutation dans leur deuxième état.

Selon un mode de réalisation de l'invention, chaque boucle est une boucle à verrouillage de phase à division fractionnaire à modulation delta-sigma, ce qui permet une diminution du bruit de phase d'origine électrique et une précision d'horloge de l'ordre de quelques Hertz.

D'autres avantages et caractéristiques de l'invention apparaîtront à l'examen de la description détaillée de modes de mise en oeuvre et de réalisation, nullement limitatifs, et des dessins annexés, sur lesquels :
- la figure 1 illustre très schématiquement l'architecture interne d'une partie d'un téléphone mobile cellulaire selon l'invention, et plus particulièrement l'architecture interne d'un étage synthétiseur de fréquence selon l'invention;
- la figure 2 illustre plus en détail mais toujours schématiquement la structure d'une boucle à verrouillage de phase à division fractionnaire utilisée dans l'invention;
- la figure 3 illustre une variante de réalisation utilisant une modulation delta-sigma pour commander le diviseur d'une boucle à verrouillage de phase à division fractionnaire ; et
- la figure 4 illustre schématiquement un mode de mise en oeuvre d'un procédé selon l'invention.

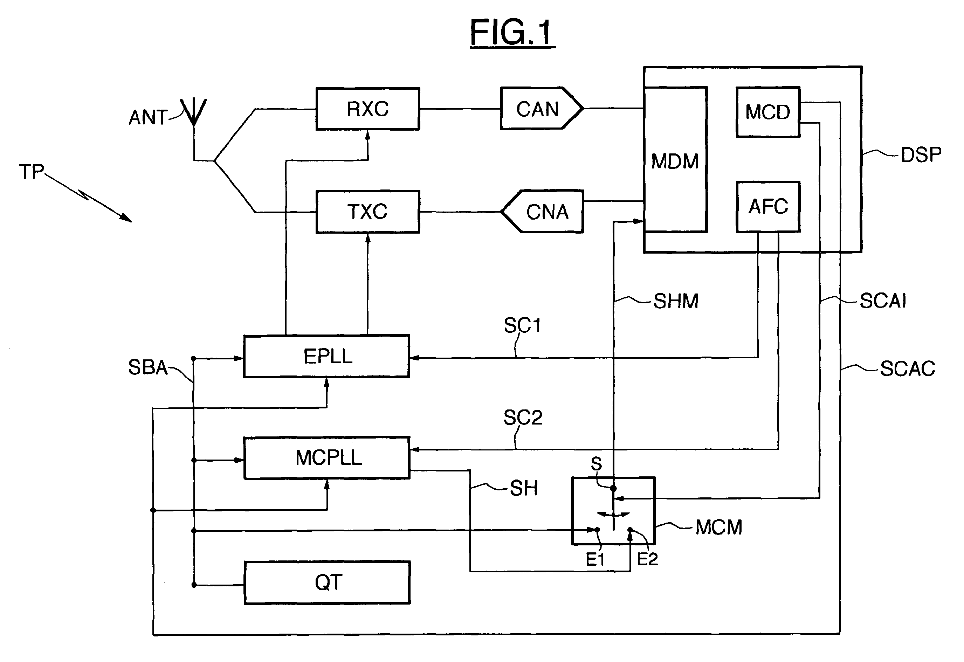

On suppose maintenant, en se référant plus particulièrement à la figure 1, que l'invention s'applique en particulier au domaine des téléphones mobiles cellulaires, par exemple ceux destinés à fonctionner selon la norme UMTS.

Une station émettrice (station de base), non représentée sur la figure 1 à des fins de simplification, comporte typiquement un bloc de codage recevant les données utiles à transmettre, par exemple de la parole, et effectuant notamment des traitements dits de "codage de canal", classiques et bien connus de l'homme du métier. La sortie de ce bloc de codage consiste en des blocs d'informations binaires. Le bloc de codage est suivi classiquement d'un modulateur effectuant par exemple une modulation en quadrature du type QPSK, selon une dénomination bien connue de l'homme du métier, et transformant le signal binaire en un signal analogique. Ce signal analogique est ensuite filtré dans un filtre d'émission avant d'être émis en direction des téléphones via une antenne, après avoir été transposé à une fréquence radio (RF).

Le téléphone mobile cellulaire TP comporte essentiellement en tête une antenne ANT couplée à un étage d'émission/réception analogique comportant pour l'essentiel, une chaîne de réception RXC et une chaîne de transmission TXC.

Dans la norme UMTS, la fréquence de réception peut être comprise entre 2110 et 2170 MHz, tandis que la fréquence d'émission, distincte de la fréquence de réception, peut être comprise entre 1920 et 1980 MHz.

Par ailleurs, l'une des exigences de la norme UMTS consiste en une précision importante de la fréquence d'émission. En effet, à titre indicatif, cette fréquence d'émission ne doit pas varier de plus de 0,1 ppm de part et d'autre de la fréquence nominale d'émission.

L'étage d'émission/réception est couplé de façon classique, par l'intermédiaire d'un étage de conversion analogique-numérique CAN et numérique-analogique CNA, à un étage numérique de traitement, réalisé matériellement en partie au moyen d'une logique câblée et en partie au moyen d'un processeur de traitement du signal DSP par exemple, et dont les différentes fonctions sont alors réalisées de façon logicielle.

Fonctionnellement, l'étage de traitement comporte (outre des moyens d'estimation de la réponse impulsionnelle du canal de transmission, des moyens de suppression des interférences intersymboles (égaliseur), et un bloc de décodage de canal) des moyens de modulation/démodulation MDM capables d'effectuer la démodulation du signal reçu et la modulation du signal à émettre.

Le téléphone portable TP comporte par ailleurs au moins une boucle à verrouillage de phase à division fractionnaire EPLL, destinée à générer et à délivrer à la chaîne de réception RXC et à la chaîne d'émission TXC des signaux de référence ayant respectivement les fréquences nominales de réception et d'émission. Dans le cas où le téléphone ne comporte qu'une seule boucle EPLL, délivrant directement le signal de référence à l'une des chaînes d'émission et de réception, il est alors prévu un moyen de décalage de fréquence pour délivrer le signal de référence à l'autre des chaînes d'émission et de réception à partir du signal de référence directement délivré par la boucle EPLL. Ceci étant, en fonction de l'architecture utilisée pour le téléphone, on peut prévoir deux boucles EPLL distinctes délivrant respectivement deux signaux de référence à la chaîne d'émission et à la chaîne de réception, fixant ainsi directement les fréquences d'émission et de réception.

Dans la suite du texte, à des fins de simplification, on supposera ici que l'on est en présence d'une seule boucle EPLL, étant bien entendu que tout ce qui va être décrit ci-après est également valable dans le cas où il existe plusieurs boucles EPLL.

La précision du signal de référence délivré par la boucle EPLL est contrôlée par un signal de commande SC1, qui est en fait un mot numérique, délivré par des moyens logiciels de contrôle automatique de fréquence AFC.

Plus précisément, les moyens de démodulation MDM effectuent une démodulation d'un signal pilote émis par la station de base sur un canal pilote ayant une fréquence prédéterminée et contenant un code prédéterminé.

Lors de la démodulation du signal pilote, le démodulateur utilise un signal d'horloge maître généré (comme on le verra plus en détail ci-après) par une boucle à verrouillage de phase MCPLL. La fréquence de ce signal d'horloge maître doit être théoriquement un multiple du taux de transmission de données sur le canal pilote ("chip rate"). Si ce n'est pas le cas, lors de la démodulation, on observera une rotation de la constellation de modulation à une fréquence correspondant à l'écart entre le taux de transmission ("chip rate") théorique et le signal d'horloge maître. L'algoritme de contrôle automatique de fréquence va alors ajuster la valeur du mot de commande de façon à stopper la rotation de cette constellation. Dans ce cas, toutes les boucles à verrouillage de phase du téléphone seront alors considérées comme calées, et les différentes horloges auront la précision requise.

Un tel algorithme de contrôle automatique de fréquence est bien connu de l'homme du métier. Celui-ci pourra notamment se référer à l'article de Aldo N. D'Andrea, intitulé "Design of Quadricorrelators for Automatic Frequency Control Systems", IEEE Transactions on Communications, Vol. 41, N° 6, Juin 1993,
ou bien à l'article de Wen-Yi Kuo, intitulé "Frequency Offset Compensation of Pilot Symbol Assisted Modulation in Frequency Flat Fading", IEEE Transactions on Communications, Vol. 45, N° 11, Novembre 1997,
ou encore à l'article de Bellini, intitulé "Digital Frequency Estimation in Burst Mode QPSK Transmission", IEEE Transactions on Communications, Vol. 38, N° 7, Juillet 1990.

Outre la ou les boucles EPLL, le téléphone comporte également une autre boucle à verrouillage de phase à division fractionnaire MCPLL, dont la sortie est reliée à la deuxième entrée E2 d'un moyen de commutation MCM à deux états (par exemple un multiplexeur à 2 entrées et 1 sortie). La sortie S du moyen de commutation MCM est reliée aux moyens de modulation/démodulation et délivre un signal d'horloge-maître SHM à ces moyens.

Les moyens MCM comportent par ailleurs une première entrée E1 reliée à la sortie d'un oscillateur à quartz QT, ayant une fréquence de base prédéterminée (par exemple 20 MHz) et une précision beaucoup plus faible que la précision requise pour la fréquence de transmission. En l'espèce, la précision de l'oscillateur à quartz est de l'ordre de ± 10 ppm.

Les moyens de commutation MCM sont commandés par un signal de commande SCAI délivré par des moyens de commande MCD. Les moyens de commande MCD sont également des moyens logiciels. Ils peuvent par ailleurs activer ou inhiber le fonctionnement des boucles EPLL et MCPLL avec un autre signal de commande SCAC.

Le signal SBA issu de l'oscillateur sert également de signal de référence pour les boucles à verrouillage de phase EPLL et MCPLL. Le signal de commande SC2, qui contrôle la précision du signal d'horloge SH délivré par la boucle MCPLL, est également délivré par les moyens de contrôle automatique de fréquence AFC et est également un mot numérique, qui est relié dans un rapport fixe, au mot de contrôle SC1.

La structure d'une boucle à verrouillage de phase à division fractionnaire est parfaitement connue de l'homme du métier, et celui-ci peut notamment se référer à l'article intitulé "Technique enhances the performance of PLL Synthetisers", Microwaves & RF, Janvier 1993, pages 59-65.

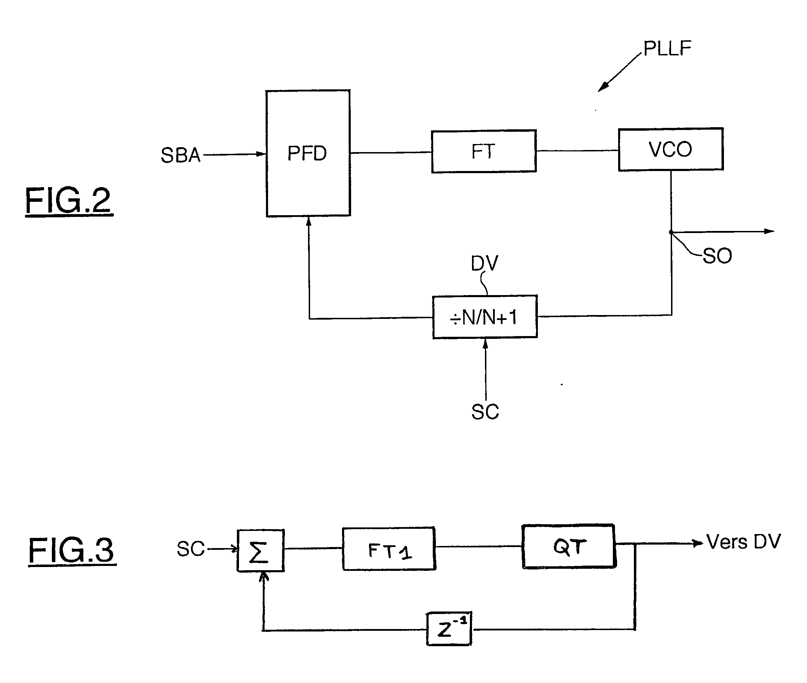

La figure 2 en rappelle les éléments essentiels.

Plus précisément, une boucle à verrouillage de phase à division fractionnaire PLLF comporte en tête un détecteur de phase et de fréquence PFD, de structure classique et parfaitement connue de l'homme du métier. La sortie de ce détecteur PFD attaque un filtre de boucle FT dont la sortie est reliée à l'entrée d'un oscillateur de boucle VCO commandé en tension. La fréquence de l'oscillateur de boucle VCO est sensiblement la fréquence de sortie désirée pour le signal de sortie délivré à la sortie SO de la boucle (qui est la sortie de l'oscillateur VCO).

La sortie de l'oscillateur VCO est rebouclée sur l'une des entrées du détecteur PFD par l'intermédiaire d'un diviseur fractionnaire DV commandé par le mot de commande SC issu des moyens de contrôle automatique de fréquence AFC. L'autre entrée du détecteur PFD reçoit le signal de base SBA issu de l'oscillateur QT.

Le nombre N est le nombre entier le plus proche (mais inférieur) du rapport entre la fréquence du signal SBA et la fréquence de l'oscillateur de boucle VCO. Par ailleurs, le rapport entre la fréquence du signal SBA et la précision requise, définit le nombre de bits du mot de contrôle SC. Ainsi, à titre d'exemple, si la fréquence de sortie de la boucle doit être égale à 2 GHz à ± 0,1 ppm, ce qui correspond à une précision de 200 Hz, et que la fréquence du signal SBA est de 20 MHz, le rapport précité est égal à 20 MHz/200 Hz, soit 100 000, ce qui est compris entre 2¹⁶ et 2¹⁷. Le mot de contrôle SC sera donc un mot de 17 bits qui va définir le nombre de fois où le diviseur DV effectuera une division par N et le nombre de fois où le diviseur DV effectuera une division par N+1, pour atteindre le rapport exact entre le signal SBA et le signal de sortie SO à ± 0,1 ppm près.

Une boucle à verrouillage de phase à division fractionnaire permet donc d'obtenir une très bonne précision sur la fréquence de sortie en utilisant un signal de base issu d'un oscillateur ayant une précision beaucoup plus faible, et par le contrôle d'un diviseur avec un mot numérique suffisamment long.

En variante, comme illustré sur la figure 3, la commande du diviseur peut résulter d'une modulation delta-sigma, également bien connue de l'homme du métier. A titre indicatif, le mot de commande SC issu des moyens AFC attaque un intégrateur. La sortie de l'intégrateur est ensuite délivrée via un filtre FT1 à l'entrée d'un moyen de quantification QT. La sortie du moyen de quantification QT est d'une part rebouclée sur l'entrée de l'intégrateur et contrôle d'autre part le diviseur DV de la boucle à verrouillage de phase.

La modulation "delta" est basée sur la quantification de la modification du signal échantillon à échantillon, plutôt que sur la quantification de la valeur absolue du signal à chaque échantillon. La présence de l'intégrateur (sigma) confère au modulateur la dénomination de "delta-sigma". Un modulateur delta-sigma est conçu pour supprimer le bruit de quantification dans la bande de base.

Le contrôle du diviseur par une modulation delta-sigma permet globalement une diminution du bruit.

L'homme du métier pourra se référer pour plus de détail concernant un exemple de boucle à verrouillage de phase à modulation delta-sigma à l'article de Perrott, intitulé "A 27-mW CMOS Fractional-N Synthesizer Using Digital Compensation for 2.5-Mb/s GFSK Modulation", IEEE Journal of Solid-State Circuits, Vol. 32, N° 12, Décembre 1997, ainsi qu'à l'article précité intitulé "Technique enhances the performance of PLL synthetisers".

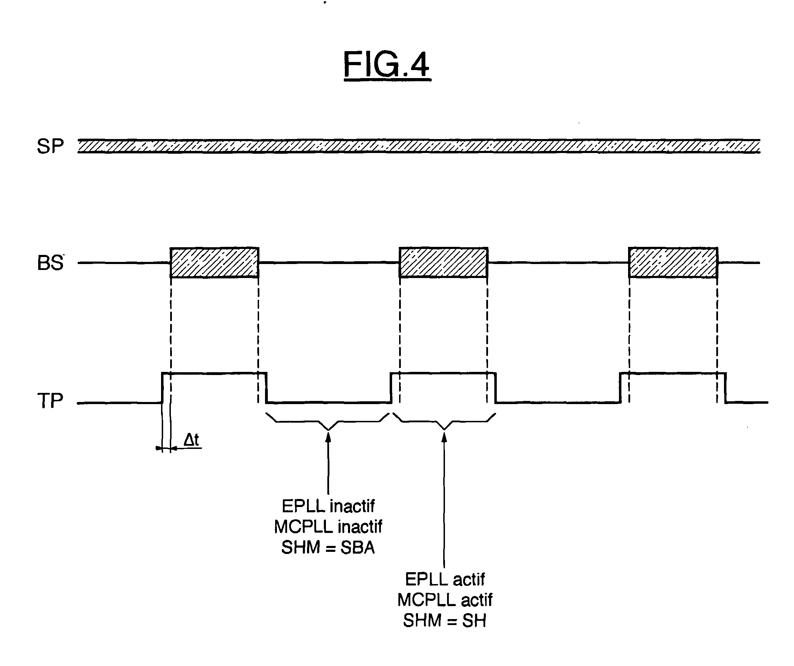

On va maintenant décrire plus en détail, en se référant plus particulièrement à la figure 4, le fonctionnement de l'étage synthétiseur de fréquence du téléphone selon l'invention.

En mode actif, c'est-à-dire lors d'une communication entre la station de base BS et le téléphone, les moyens de commande MCD activent les boucles à verrouillage de phase EPLL et MCPLL et placent les moyens de commutation MCM dans leur deuxième état reliant la deuxième sortie E2 à la sortie S. En conséquence, le signal d'horloge-maître SHM délivré au moyen de modulation/démodulation est le signal d'horloge SH délivré par la boucle MCPLL (soit un multiple du taux de transmission du signal pilote ("chip rate"), par exemple 15,36 MHz pour un taux de transmission ("chip rate") égal à 3,84 Mcps comme dans la norme UMTS)).

La précision du signal SHM et des signaux de référence délivrés à l'étage d'émission/réception, est alors égale à ± 0,1 ppm, cette précision étant contrôlée par les mots de contrôle SC1 et SC2, à travers l'algorithme automatique de fréquence.

En mode d'attente, comme illustré sur la figure 4, la station de base BS communique à des intervalles réguliers avec le téléphone portable TP, le signal pilote SP étant quant à lui émis en permanence.

En-dehors des périodes de dialogue entre la station de base BS et le téléphone TP, les moyens de commande MCD rendent inactives les boucles EPLL et MCPLL et placent les moyens de commutation MCM dans leur premier état reliant la première entrée E1 avec la sortie S. Dans ce cas, le signal d'horloge-maître SHM délivré à l'étage de traitement est le signal de base SBA délivré par l'oscillateur QT. En conséquence, l'étage de traitement, et en particulier les moyens de modulation/démodulation, reçoivent un signal d'horloge dont la précision est égale à celle de l'oscillateur QT, à savoir en l'espèce ± 10 ppm. Cependant, cette précision est largement suffisante au cours de ces périodes de non dialogue.

Par contre, juste avant chaque période de dialogue entre la station de base BS et le téléphone portable, les moyens de commande MCD rendent actives les boules EPLL et MCPLL et placent les moyens de commutation MCM de nouveau dans leur deuxième état. Au début de l'activation de la boucle MCPLL, le signal SHM (signal SH) est délivré avec une précision de ± 10 ppm. Cependant, cette précision est suffisante pour permettre aux moyens de contrôle automatique de fréquence AFC d'effectuer le contrôle de fréquence et de délivrer les mots de contrôle SC 1 et SC2, de façon à ramener la précision à ± 0,1 ppm au bout de la durée ΔT, c'est-à-dire lorsque le dialogue avec la station de base commence effectivement (typiquement ΔT peut être de l'ordre de quelques microsecondes en fonction de l'architecture utilisée).

A la fin de la période de dialogue, les moyens de commande désactivent de nouveau les boucles EPLL et MCPLL et remettent les moyens de commutation MCM dans leur deuxième état.

## Revendications

1. Procédé de réduction de la consommation électrique d'un émetteur/récepteur d'informations numériques, en particulier un téléphone mobile cellulaire, comportant un étage synthétiseur de fréquence, contrôlé par un algorithme de contôle automatique de fréquence et apte à délivrer au moins un signal de référence de fréquence choisie à l'étage d'émission/réception du téléphone et un signal d'horloge-maître de fréquence choisie aux moyens de modulation/démodulation de l'émetteur/récepteur, **caractérisé par le fait qu'**on génère le ou les signaux de référence avec une précision d'émission prédéterminée, à partir d'au moins une première boucle à verrouillage de phase à division fractionnaire (EPLL) contrôlée par l'algorithme de contrôle automatique de fréquence et recevant un signal de base (SBA) ayant une fréquence de base prédéterminée et une précision de base inférieure à ladite précision d'émission, on génère un signal d'horloge (SH) avec une précision prédéterminée, à partir d'une deuxième boucle à verrouillage de phase à division fractionnaire (MCPLL) contrôlée par l'algorithme de contrôle automatique de fréquence et recevant le signal de base, et lorsque l'étage d'émission/réception est inactif on rend inactif la deuxième boucle à verrouillage de phase à division fractionnaire (MCPLL), le signal de base (SBA) étant alors le signal d'horloge-maître, et lorsque l'étage d'émission/réception est actif on active la deuxième boucle, le signal d'horloge (SH) délivré par cette boucle étant alors le signal d'horloge-maître (SHM).

2. Dispositif d'émission/réception d'informations numériques, en particulier téléphone mobile cellulaire, comportant un étage d'émission/réception (RXC, TXC), un étage de traitement (DSP) connecté à l'étage d'émission/réception et comportant des moyens de modulation/démodulation (MDM) et des moyens de contrôle automatique de fréquence (AFC), et un étage synthétiseur de fréquence contrôlé par les moyens de contrôle automatique de fréquence et apte à délivrer au moins un signal de référence de fréquence choisie à l'étage d'émission/réception et un signal d'horloge-maître de fréquence choisie aux moyens de modulation/démodulation, **caractérisé par le fait que** l'étage synthétiseur de fréquence comporte
au moins une première boucle à verrouillage de phase à division fractionnaire (EPLL) dont la sortie, reliée à l'étage d'émission/réception, est apte à délivrer, avec une précision d'émission prédéterminée, le signal de référence et une deuxième boucle à verrouillage de phase à division fractionnaire (MCPLL) dont la sortie est apte à délivrer, avec une précision prédéterminée, un signal d'horloge (SH), chaque boucle étant apte à prendre sur commande un état actif et un état inactif et possédant une entrée de contrôle reliée aux moyens de contrôle automatique de fréquence, ainsi qu'une entrée pour recevoir un signal de base (SBA) issu d'un oscillateur (QT) et ayant une fréquence de base prédéterminée et une précision de base inférieure à ladite précision d'émission, et
des moyens de commutation commandables (MCM) possédant un premier état reliant la sortie de l'oscillateur (QT) aux moyens de modulation/démodulation (MDM) et un deuxième état reliant la sortie de la deuxième boucle (MCPLL) aux moyens de modulation/démodulation,
et **par le fait que** le dispositif comprend en outre des moyens de commande (MCD) aptes à placer la deuxième boucle dans son état inactif et les moyens de commutation dans leur premier état, et à placer la deuxième boucle dans son état actif et les moyens de commutation dans leur deuxième état.

3. Dispositif selon la revendication 1, **caractérisé par le fait que** chaque boucle (EPLL, MCPLL) est une boucle à verrouillage de phase à division fractionnaire à modulation delta-sigma.

## Claims

1. Process for reducing the electrical consumption of a transmitter/receiver of digital information, in particular a cellular mobile telephone, comprising a frequency synthesizer stage controlled by an automatic frequency control algorithm and able to deliver at least one reference signal of chosen frequency to the transmission/reception stage of the telephone and a master-clock signal of chosen frequency to the modulation/demodulation means of the transmitter/receiver, **characterized in that** the reference signal or signals are generated with a predetermined transmission accuracy, on the basis of at least a first fractional-division phase-locked loop (EPLL) controlled by the automatic frequency control algorithm and receiving a base signal (SBA) having a predetermined base frequency and a base accuracy lower than the said transmission accuracy, a clock signal (SH) is generated with a predetermined accuracy, on the basis of a second fractional-division phase-locked loop (MCPLL) controlled by the automatic frequency control algorithm and receiving the base signal, and when the transmission/reception stage is inactive, the second fractional-division phase-locked loop (MCPLL) is rendered inactive, the base signal (SBA) then being the master-clock signal, and when the transmission/reception stage is active, the second loop is activated, the clock signal (SH) delivered by this loop then being the master-clock signal (SHM).

2. Device for transmitting/receiving digital information, in particular cellular mobile telephone, comprising a transmission/reception stage (RXC, TXC), a processing stage (DSP) connected to the transmission/reception stage and comprising modulation/demodulation means (MDM) and automatic frequency control means (AFC), and a frequency synthesizer stage controlled by the automatic frequency control means and able to deliver at least one reference signal of chosen frequency to the transmission/reception stage and a master-clock signal of chosen frequency to the modulation/demodulation means, **characterized in that** the frequency synthesizer stage comprises
at least a first fractional-division phase-locked loop (EPLL) whose output, linked to the transmission/reception stage, is able to deliver, with a predetermined transmission accuracy, the reference signal and a second fractional-division phase-locked loop (MCPLL) whose output is able to deliver, with a predetermined accuracy, a clock signal (SH), each loop being able to adopt on command an active state and an inactive state and possessing a control input linked to the automatic frequency control means, as well as an input for receiving a base signal (SBA) emanating from an oscillator (QT) and having a predetermined base frequency and a base accuracy lower than the said transmission accuracy, and
controllable switching means (MCM) possessing a first state linking the output of the oscillator (QT) to the modulation/demodulation means (MDM) and a second state linking the output of the second loop (MCPLL) to the modulation/demodulation means,
and **in that** the device furthermore comprises control means (MCD) able to place the second loop in its inactive state and the switching means in their first state, and to place the second loop in its active state and the switching means in their second state.

3. Device according to claim 1, **characterized in that** each loop (EPLL, MCPLL) is a delta-sigma modulation fractional-division phase-locked loop.

## Patentansprüche

1. Verfahren zur Reduzierung des Elektrizitätsverbrauchs eines Senders/Empfängers digitaler Daten, insbesondere eines zellularen Mobiltelefons, das eine Frequenzaufbereitungsstufe aufweist, die von einem Algorithmus zur automatischen Frequenzsteuerung gesteuert wird und in der Lage ist, mindestens ein Referenzsignal einer gewählten Frequenz zu der Sende/Empfangsstufe des Telefons und ein Haupttaktsignal einer gewählten Frequenz zu Modulation/Demodulation-Einrichtungen des Senders/Empfängers auszugeben, **dadurch gekennzeichnet, daß**
von mindestens einer ersten Multiplex-Phasenverriegelungsschleife (EPLL), die von dem Algorithmus zur automatischen Frequenzsteuerung gesteuert wird und ein Basissignal (SBA) empfängt, das eine vorgegebene Basisfrequenz und eine geringere Basispräzision als eine Sendepräzision hat, das oder die Referenzsignale mit der vorgegebenen Sendepräzision erzeugt werden,
von einer zweiten Multiplex-Phasenverriegelungsschleife (MCPLL), die von dem Algorithmus zur automatischen Frequenzsteuerung gesteuert wird und das Basissignal (SBA) empfängt, ein Taktsignal (SH) mit einer vorgegebenen Präzision erzeugt wird, und
wenn die Sende/Empfangsstufe inaktiv ist, die zweite Multiplex-Phasenverriegelungsschleife (MCLPP) inaktiviert wird, wobei das Basissignal (SBA) dann das Haupttaktsignal ist, und wenn die Sende/Empfangsstufe aktiv ist, die zweite Schleife aktiviert wird, wobei das von dieser Schleife ausgegebene Taktsignal (SH) dann das Haupttaktsignal (SHM) ist.

2. Sende/Empfangsvorrichtung für digitale Daten, insbesondere zellulares Mobiltelefon, aufweisend:
eine Sende/Empfangsstufe (RXC,TXC),
eine Verarbeitungsstufe (DSP), die mit der Sende/Empfangsstufe verbunden ist und Modulation/Demodulation-Einrichtungen (MDM) und Einrichtungen (AFC) zur automatischen Frequenzsteuerung aufweist, und
eine Frequenzaufbereitungsstufe, die von den Einrichtungen zur automatischen Frequenzsteuerung gesteuert wird und in der Lage ist, mindestens ein Referenzsignal einer gewählten Frequenz zu der Sende/Empfangsstufe und ein Haupttaktsignal einer gewählten Frequenz zu den Modulation/Demodulation-Einrichtungen auszugeben,
**dadurch gekennzeichnet, daß**
die Frequenzaufbereitungsstufe aufweist:
mindestens eine erste Multiplex-Phasenverriegelungsschleife (EPLL), deren mit der Sende/Empfangsstufe verbundener Ausgang in der Lage ist, mit einer vorgegebenen Sendepräzision das Referenzsignal auszugeben, und eine zweite Multiplex-Phasenverriegelungsschleife (MCLPP), deren Ausgang in der Lage ist, mit einer vorgegebenen Präzision ein Taktsignal (SH) auszugeben, wobei jede Schleife in der Lage ist, auf Befehl einen aktiven Zustand und einen inaktiven Zustand anzunehmen, und einen Steuereingang aufweist, der mit den Einrichtungen zur automatischen Frequenzsteuerung verbunden ist, sowie einen Eingang aufweist, um ein von einem Oszillator (QT) ausgegebenes Basissignal (SBA) zu empfangen, das eine vorgegebene Basisfrequenz und eine geringere Basispräzision als die Sendepräzision hat, und
steuerbare Schalteinrichtungen (MCM), die einen ersten Zustand aufweisen, der den Ausgang des Oszillators (QT) mit den Modulation/Demodulation-Einrichtungen (MDM) verbindet, und einen zweiten Zustand aufweisen, der den Ausgang der zweiten Schleife (MCPLL) mit den Modulation/Demodulation-Einrichtungen verbindet,
und **dadurch, daß** die Vorrichtung ferner Steuereinrichtungen (MCD) aufweist, die in der Lage sind, die zweite Schleife in ihren inaktiven Zustand und die Schalteinrichtungen in ihren ersten Zustand zu setzen, sowie die zweite Schleife in ihren aktiven Zustand und die Schalteinrichtungen in ihren zweiten Zustand zu setzen.

3. Vorrichtung nach Anspruch 1, **dadurch gekennzeichnet, daß** jede Schleife (EPLL, MCPLL) eine Multiplex-Phasenverriegelungsschleife einer Delta-Sigma-Modulation ist.
